(19) **Europäisches Patentamt / European Patent Office / Office européen des brevets**

(11) **EP 3 510 644 B1**

(12) **FASCICULE DE BREVET EUROPEEN**

(45) Date de publication et mention de la délivrance du brevet:
**06.04.2022 Bulletin 2022/14**

(21) Numéro de dépôt: **17768728.2**

(22) Date de dépôt: **08.09.2017**

(51) Classification Internationale des Brevets (IPC):
***H01L 45/00*** *(2006.01)*

(52) Classification Coopérative des Brevets (CPC):
**H01L 45/085; H01L 27/2472; H01L 45/1233; H01L 45/1246; H01L 45/146; H01L 45/165**

(86) Numéro de dépôt international:
**PCT/EP2017/072622**

(87) Numéro de publication internationale:
**WO 2018/046683 (15.03.2018 Gazette 2018/11)**

(54) **CELLULE MEMOIRE NON-VOLATILE RESISTIVE A BASE D'OXYDE ET SON PROCEDE DE FABRICATION**

OXIDBASIERTE RESISTIVE NICHTFLÜCHTIGE SPEICHERZELLE UND VERFAHREN ZUR HERSTELLUNG DAVON

OXIDE-BASED RESISTIVE NON-VOLATILE MEMORY CELL AND METHOD FOR MANUFACTURING SAME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.09.2016 FR 1658446**

(43) Date de publication de la demande:
**17.07.2019 Bulletin 2019/29**

(73) Titulaire: **Commissariat à l'Énergie Atomique et aux Énergies Alternatives 75015 Paris (FR)**

(72) Inventeurs:
• **GRENOUILLET, Laurent 38640 Claix (FR)**
• **BARLAS, Marios 38400 St Martin d'Hères (FR)**
• **BLAISE, Philippe 38000 Grenoble (FR)**
• **SKLENARD, Benoît 38100 Grenoble (FR)**
• **VIANELLO, Elisa 38000 Grenoble (FR)**

(74) Mandataire: **Cabinet Camus Lebkiri 25 rue de Maubeuge 75009 Paris (FR)**

(56) Documents cités:
**US-A1- 2012 069 624     US-A1- 2012 295 398 US-A1- 2014 322 887**

**Description**

**DOMAINE TECHNIQUE DE L'INVENTION**

Le domaine technique de l'invention est celui des mémoires non-volatiles, et plus particulièrement celui des mémoires résistives à base d'oxyde.

**ARRIÈRE-PLAN TECHNOLOGIQUE DE L'INVENTION**

Les mémoires résistives sont des mémoires non-volatiles mais qui présentent des vitesses de fonctionnement suffisamment élevées pour prétendre remplacer à la fois les mémoires vives et les mémoires non-volatiles actuelles telles que les mémoires de type flash.

Les mémoires résistives sont basées sur un matériau actif pouvant basculer de manière réversible entre deux états de résistance qui permettent de coder un bit d'information. Il existe des mémoires résistives pour lesquelles le matériau actif est à base d'oxyde. C'est le cas notamment des mémoires de type OxRAM, pour « Oxide resistive Random Access Memory » en anglais, et de certaines mémoires de type CBRAM, pour « Conductive Bridging Random Access Memory » en anglais.

Les mémoires résistives à base d'oxyde présentent une forte densité d'intégration et sont compatibles avec les procédés de fabrication de la technologie CMOS. Les mémoires résistive à base d'oxyde peuvent être intégrées aussi bien en fin de ligne de fabrication, ce qu'on appelle BEOL pour « Back-End-Of-Line » en anglais, qu'en début de ligne de fabrication, ce qu'on appelle FEOL pour « Front-End-Of-Line » en anglais.

Une mémoire résistive à base d'oxyde comprend une multitude de cellule mémoires agencées en lignes et en colonne pour former une matrice. Chaque cellule mémoire comporte une couche d'oxyde disposée entre deux électrodes. La couche d'oxyde bascule de manière réversible entre deux états de résistance en fonction de la tension appliquée sur la cellule mémoire. Une tension d'écriture est utilisée pour passer la couche d'oxyde dans un état à faible résistance, tandis qu'une tension d'effacement est utilisée pour passer la couche d'oxyde dans un état à forte résistance.

Le changement d'état de résistance est lié à la formation et à la rupture, dans la couche d'oxyde, d'une zone de commutation, également appelée « switching zone » en anglais, qui forme un chemin conducteur électriquement reliant les électrodes de la cellule mémoire. Par exemple, dans les mémoires CBRAM, le chemin conducteur est un filament formé par des ions métalliques, et dans les mémoires OxRAM, la formation du chemin conducteur est attribuée à l'accumulation de lacunes d'oxygène au sein de la couche d'oxyde.

Cependant, ces modes de conduction impliquent une grande variabilité des états de résistance parmi les différentes cellules mémoires de la matrice. Une cause de variabilité provient de l'endroit de la couche d'oxyde où se forme la zone de commutation. En particulier, les bords d'une cellule mémoire présentent des défauts, notamment dus à leur gravure, qui introduisent une variabilité supplémentaire lorsque la zone de commutation se forme près de l'un de ces bords.

Idéalement, les états de résistance ont chacun une valeur discrète mais en pratique, les états de résistance s'étalent chacun sur une plage de valeurs. Les états de résistance peuvent donc se recouvrir, ce qui rend difficile la distinction entre l'état à faible résistance et l'état à forte résistance. Afin d'éviter cela, il peut donc être nécessaire d'augmenter la taille de la fenêtre mémoire des cellules, c'est-à-dire l'écart entre les valeurs de résistance définissant l'état à faible résistance et l'état à forte résistance.

Il est possible de fabriquer une cellule mémoire avec une fenêtre mémoire élevée mais au détriment d'autres caractéristiques de la cellule mémoire telles que le temps pendant lequel le bit d'information peut être stocké dans la cellule lorsque la température augmente, ce que l'on appelle « data rétention » en anglais, et au cyclage, c'est-à-dire le nombre de fois qu'il est possible d'écrire dans la cellule mémoire, ce que l'on appelle « endurance » en anglais.

Dans le but d'améliorer les performances des cellules mémoires résistives à base d'oxyde, il apparaît donc un besoin de réduire la variabilité des états de résistance des cellules mémoires en contrôlant la localisation de la zone de commutation dans la couche d'oxyde.

Il est connu du document HAYAKAWA Y. et al. 'Highly reliable TaOx ReRAM with centralized filament for 28-nm embedded application'. In : 2015 Symposium on VLSI Technology, Kyoto, ISSN 0743-1562, d'effectuer une oxydation des bords de la cellule mémoire ayant pour effet la formation de la zone de commutation au centre de la cellule mémoire.

Cependant, pour être applicable, cette méthode nécessite de graver la couche d'oxyde afin d'exposer ses bords à l'oxydation, ce qui complique la mise en œuvre de cette méthode. D'autres exemples de l'art antérieur se trouve dans les brevets US2012/295398, US2012/69624 et US2014/322887.

**RÉSUMÉ DE L'INVENTION**

La présente invention vise à fournir une cellule mémoire non-volatile résistive à base d'oxyde dans laquelle la localisation du filament est contrôlée de manière simple, la cellule mémoire présentant ainsi une plus faible variabilité.

A cette fin, l'invention propose une cellule mémoire non-volatile résistive comportant une première électrode, une deuxième électrode et une couche d'oxyde disposée entre la première électrode et la deuxième électrode, la cellule mémoire étant apte à commuter de manière réversible entre :

- un état à forte résistance obtenu en appliquant une première tension de polarisation entre la première électrode et la deuxième électrode ; et
- un état à faible résistance en appliquant une deuxième tension de polarisation entre la première électrode et la deuxième électrode ;

la couche d'oxyde comportant une zone de commutation formant un chemin de conduction privilégié au courant traversant la cellule mémoire lorsque la cellule mémoire est à l'état à faible résistance, la couche d'oxyde comportant une première zone dopée avec de l'aluminium ou du silicium, l'aluminium ou le silicium étant présent dans la première zone à une concentration atomique choisie de manière à localiser la zone de commutation en dehors de la première zone.

Avant toute utilisation de la cellule mémoire, une tension de formation, également appelée « forming voltage » en anglais, est appliquée à la cellule mémoire afin de former la zone de commutation pour la première fois. Il a été constaté qu'en dopant de manière appropriée la première zone avec de l'aluminium ou du silicium, pour former la zone de commutation dans la première zone dopée, il est nécessaire d'appliquer à la cellule mémoire une première tension de formation supérieure à une tension de formation de référence qu'il faut appliquer pour former la zone de commutation dans la couche d'oxyde non dopée. En d'autres termes, en maintenant la tension de formation inférieure à la première tension de formation, la zone de commutation se forme là où la couche d'oxyde n'est pas dopée. Grâce à l'invention, il est donc possible de contrôler de manière simple la localisation de la zone de commutation par un dopage approprié de la couche d'oxyde, ce qui permet ainsi de réduire la variabilité des cellules mémoires.

La cellule mémoire selon le premier aspect de l'invention peut également comporter une ou plusieurs caractéristiques parmi les suivantes, considérées individuellement ou selon les combinaisons techniquement possibles :

- la première zone dopée s'étend à la périphérie de la cellule mémoire ; Ainsi, la localisation de la zone de commutation est éloignée des bords de la cellule mémoire.
- la première zone est dopée avec du silicium, la concentration atomique en silicium dans la première zone est comprise entre 0,1% et 2% ;
- la couche d'oxyde comporte une deuxième zone dopée avec du silicium, le silicium étant présent dans la deuxième zone à une concentration atomique choisie de manière à localiser la zone de commutation dans la deuxième zone ;
- la première zone entoure complètement la deuxième zone ;
- la première zone comporte :

  ∘ une première portion et une deuxième portion s'étendant de part et d'autre de la deuxième zone selon une première direction ;
  ∘ une troisième portion et une quatrième portion s'étendant de part et d'autre de la deuxième zone selon une deuxième direction sensiblement orthogonale à la première direction ;

- la concentration atomique en silicium dans la deuxième zone est supérieure à 3% ;
- la couche d'oxyde (3) comporte un matériau parmi les suivants : oxyde de hafnium, oxyde de titane, oxyde de tantale.

Un deuxième aspect de l'invention concerne un procédé de fabrication d'une cellule mémoire non-volatile résistive comportant une première électrode, une deuxième électrode et une couche d'oxyde disposée entre la première électrode et la deuxième électrode, la cellule mémoire étant apte à commuter de manière réversible entre :

- un état à forte résistance obtenu en appliquant une première tension de polarisation entre la première électrode et la deuxième électrode ; et
- un état à faible résistance en appliquant une deuxième tension de polarisation entre la première électrode et la deuxième électrode ;

la couche d'oxyde comportant une zone de commutation formant un chemin de conduction privilégié au courant traversant la cellule mémoire lorsque la cellule mémoire est à l'état à faible résistance, le procédé comportant une étape de formation dans la couche d'oxyde d'une première zone dopée avec de l'aluminium ou du silicium, l'aluminium ou le silicium étant présent dans la première zone à une concentration atomique choisie de manière à localiser la zone de commutation en dehors de la première zone.

Le procédé de fabrication selon le deuxième aspect de l'invention peut également comporter une ou plusieurs caractéristiques parmi les suivantes, considérées individuellement ou selon les combinaisons techniquement possibles :

- l'étape de formation comporte une première étape d'implantation ionique d'aluminium ou de silicium dans la première zone ;
- l'étape de formation comporte une première étape d'implantation ionique de silicium dans une première région de la couche d'oxyde et une deuxième étape d'implantation ionique de silicium dans une deuxième région de la couche d'oxyde, la première région et la deuxième région se confondant au moins partiellement et formant :

  ∘ la première zone de la couche d'oxyde dans laquelle la première région et la deuxième région ne sont pas confondues ; et

○ une deuxième zone de la couche d'oxyde dans laquelle la première région et la deuxième région sont confondues ;

la première étape d'implantation et la deuxième étape d'implantation étant effectuées à des doses telles que le silicium est présent dans la deuxième zone à une concentration atomique totale choisie de manière à localiser la zone de commutation dans la deuxième zone ;

- la première étape d'implantation comporte une première opération de masquage de la couche d'oxyde réalisée de manière à ce que la première région forme une première tranchée s'étendant selon une première direction, et en ce que la deuxième étape d'implantation comporte une deuxième opération de masquage de la couche d'oxyde réalisée de manière à ce que la deuxième région forme une deuxième tranchée s'étendant selon une deuxième direction sensiblement orthogonale à la première direction, la deuxième tranchée croisant la première tranchée, la deuxième zone étant formée par l'intersection de la première tranchée et de la deuxième tranchée ;
- le procédé comporte une étape de dépôt, sur la couche d'oxyde, d'une couche conductrice électriquement destinée à former une électrode, la première étape d'implantation et/ou la deuxième étape d'implantation étant effectuées après l'étape de dépôt de la couche conductrice électriquement.

## BRÈVE DESCRIPTION DES FIGURES

L'invention et ses différentes applications seront mieux comprises à la lecture de la description qui suit et à l'examen des figures qui l'accompagnent, parmi lesquelles :

- la figure 1A représente schématiquement une vue en coupe transversale d'un premier mode de réalisation d'une cellule mémoire selon l'invention ;
- la figure 1B représente schématiquement une vue de dessus de la couche d'oxyde de la cellule mémoire de la figure 1A ;
- la figure 2A représente schématiquement une vue en coupe transversale d'un deuxième mode de réalisation d'une cellule mémoire selon l'invention ;
- la figure 2B représente schématiquement une vue de dessus de la couche d'oxyde de la cellule mémoire de la figure 2A ;
- la figure 3A représente schématiquement une vue en coupe transversale d'un troisième mode de réalisation d'une cellule mémoire selon l'invention ;
- la figure 3B représente schématiquement une vue de dessus de la couche d'oxyde de la cellule mémoire de la figure 3A ;
- la figure 4 montre la variation de la tension de formation de la zone de commutation dans une couche d'oxyde de hafnium de 10nm d'épaisseur en fonction de la concentration atomique, exprimée en pourcentage, de silicium ou d'aluminium présent dans la couche d'oxyde de hafnium ;
- la figure 5 illustre les étapes principales d'un procédé de fabrication d'une cellule mémoire selon l'invention telles que les cellules mémoires des figures 1A, 2A ou 3A ;
- les figures 6A et 6B représentent schématiquement une première étape d'implantation d'un procédé de fabrication de la cellule mémoire de la figure 1A, respectivement en vue de coupe transversale et en vue de dessus ;
- les figures 7A et 7B représentent schématiquement une deuxième étape d'implantation d'un procédé de fabrication de la cellule mémoire de la figure 2A, respectivement en vue de coupe transversale et en vue de dessus ;
- les figures 8A et 8B représentent schématiquement en vue de dessus respectivement une première étape d'implantation et une deuxième étape d'implantation d'un procédé de fabrication de la cellule mémoire de la figure 3A ;
- la figure 8C représente schématiquement une vue de dessus de la couche d'oxyde d'une pluralité de cellules mémoire de la figure 3A
- la figure 9 représente schématiquement une deuxième étape d'implantation ionique selon un mode de mise en œuvre du procédé de l'invention.

Les figures ne sont présentées qu'à titre indicatif et nullement limitatif de l'invention.

Pour plus de clarté, les éléments identiques ou similaires sont repérés par des signes de référence identiques sur toutes les figures.

## DESCRIPTION DÉTAILLÉE DE MODES DE REALISATION DE L'INVENTION

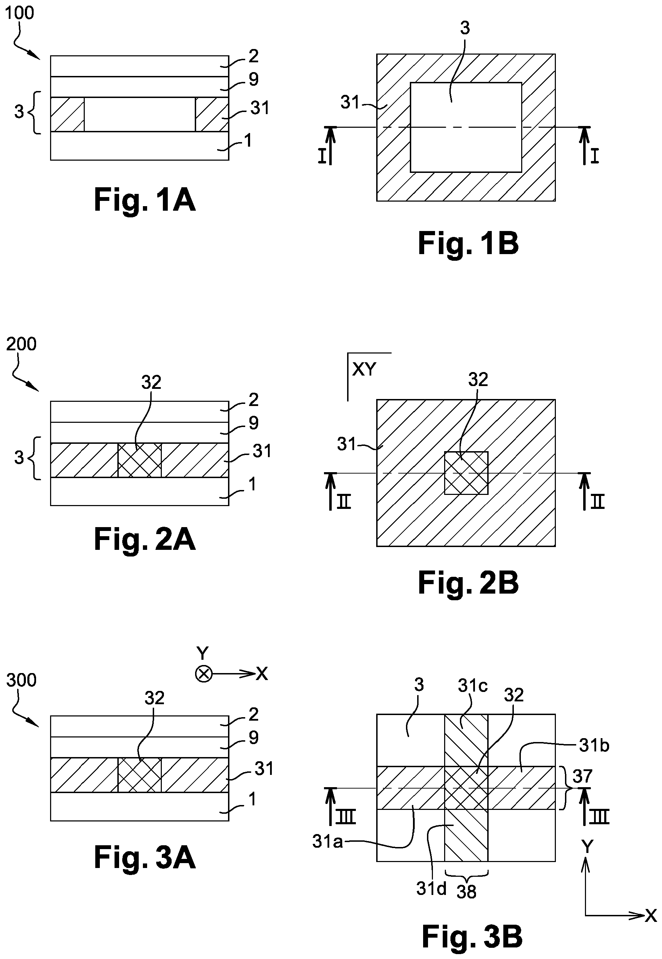

Différents modes de réalisation d'une cellule mémoire selon l'invention vont maintenant être décrits, en références aux figures 1A à 3B.

Quel que soit le mode de réalisation, la cellule mémoire comporte une première électrode 1, une deuxième électrode 2 et une couche d'oxyde 3 disposée entre la première électrode 1 et la deuxième électrode 2. La première électrode 1 est par exemple disposée sur un substrat (non représenté), la première électrode 1 étant désignée comme électrode inférieure. La deuxième électrode 2 est alors désignée comme électrode supérieure.

Dans le contexte de l'invention, les termes « inférieure » et « supérieure » sont utilisés pour caractériser la position des électrodes dans le référentiel du substrat.

Le substrat est par exemple en silicium et peut comporter d'autres couches déjà formées dessus.

Les électrodes 1, 2 sont des couches conductrices électriquement et peuvent comporter un ou plusieurs matériaux conducteurs tels que le nitrure de titane, le silicium dopé, le tungstène, le nitrure de tungstène, les siliciures de métal, le platine. Les électrodes 1, 2 présentent une épaisseur de préférence comprise entre 5nm et 30 nm.

La couche d'oxyde 3 comporte de préférence un oxyde d'un métal de transition tel que l'oxyde de hafnium, l'oxyde de tantale, l'oxyde de titane, l'oxyde de nickel, l'oxyde de tungstène ou l'oxyde de zinc. La couche d'oxyde 3 peut également comporter de l'oxyde de silicium, de l'oxyde d'aluminium, de l'oxyde d'indium ou de l'oxyde de gadolinium. Eventuellement, la couche d'oxyde 3 peut comporter plusieurs sous-couches d'oxydes superposées. La couche d'oxyde 3 présente une épaisseur de préférence comprise entre 3nm et 20nm, et plus préférentiellement encore comprise entre 5nm et 10nm.

La cellule mémoire est une cellule mémoire à base d'oxyde dont le fonctionnement est le suivant. La couche d'oxyde 3, et de manière plus générale la cellule mémoire, peut basculer de manière réversible entre deux états de résistance. Lorsqu'une tension est appliquée à la cellule mémoire, cette dernière est traversée par un courant de plus ou moins forte intensité selon l'état de résistance dans lequel se trouve la cellule mémoire.

Au cours d'une opération d'écriture, une tension d'écriture est appliquée à la cellule mémoire pour former une zone de commutation dans la couche d'oxyde 3, entre les électrodes 1, 2. La cellule mémoire passe ainsi dans un état à faible résistance, également appelé LRS pour « Low Résistance State » en anglais. Dans cet état, le courant traversant la cellule mémoire est considérée comme étant de forte intensité, et ce courant passe principalement à travers la zone de commutation qui présente une plus faible résistance que le reste de la couche d'oxyde 3.

Au cours d'une opération d'effacement, une tension d'effacement est appliquée à la cellule mémoire pour rompre la zone de commutation. La cellule mémoire passe ainsi dans un état à forte résistance, également appelé HRS pour « High Résistance State » en anglais. Dans cet état, le courant traversant la cellule mémoire est considérée comme étant de faible intensité.

Lorsque la cellule mémoire se trouve dans son état originel, juste après sa fabrication, la zone de commutation est formée pour la première fois en appliquant à la cellule mémoire une tension de formation supérieure à la tension d'écriture. Ensuite, la cellule mémoire entre dans un mode de fonctionnement normal dans lequel la tension d'écriture et la tension d'effacement sont utilisées pour faire basculer l'état de résistance de la cellule mémoire.

Une fois que la zone de commutation s'est formée pour la première fois à un endroit de la couche d'oxyde 3, elle se reforme toujours à cet endroit au cours des opérations d'écriture ultérieures.

A tout moment, l'état de résistance dans lequel se trouve la cellule mémoire peut être déterminé en lui appliquant une tension de lecture.

Dans les cellules mémoires de type OxRAM, une explication à la formation de la zone de commutation est l'accumulation de lacunes d'oxygène au sein de la couche d'oxyde 3. Avantageusement, la cellule mémoire peut comporter une couche 9 formée avec un matériau ayant une forte affinité avec l'oxygène, cette couche formant ainsi un réservoir de lacunes d'oxygène qui facilite la formation de la zone de commutation en fournissant les lacunes nécessaires. La couche de réservoir 9 est par exemple disposée entre la couche d'oxyde 3 et l'électrode supérieure 2. La couche de réservoir présente une épaisseur de préférence comprise entre 2nm et 10nm, et plus préférentiellement encore comprise entre 3nm et 7nm. La couche de réservoir 9 comporte par exemple du titane, du zirconium, du hafnium ou du lanthane.

La présente invention est basée sur la constatation selon laquelle, lorsque la couche d'oxyde 3 est dopée avec de l'aluminium ou du silicium, la tension de formation de la zone de commutation dans la couche d'oxyde 3 varie en fonction de la concentration atomique en aluminium ou en silicium dans la couche d'oxyde 3.

Dans la suite de la description, le terme « élément dopant » fait indifféremment référence à l'aluminium ou au silicium.

Dans l'ensemble de la description et dans les revendications, la concentration atomique C de l'élément dopant dans une zone considérée de la couche d'oxyde 3 est exprimée en pourcentage et est définie par la relation suivante :

$$C = 100 * \frac{C_{dopant}}{C_{Ox} + C_{dopant}}$$

où $C_{dopant}$ est la concentration d'atomes de l'élément dopant présents dans la zone considérée, et $C_{Ox}$ est la concentration d'atomes constituant la couche d'oxyde 3 non dopée, ces concentrations $C_{dopant}$ et $C_{Ox}$ étant exprimées en nombre d'atomes par $cm^{-3}$.

La tension de formation lorsque la concentration atomique de l'élément dopant est nulle, c'est-à-dire lorsque la couche d'oxyde 3 n'est pas dopée, est prise comme tension de référence. Lorsque la couche d'oxyde 3 est dopée avec du silicium, la tension de formation commence par augmenter avec la concentration atomique en silicium jusqu'à atteindre une valeur maximale. Ensuite, lorsque la concentration atomique en silicium continue d'augmenter, la tension de formation diminue, en passant sous la tension de référence. Lorsque la couche d'oxyde 3 est dopée avec de l'aluminium, la tension de formation augmente linéairement avec la concentration atomique en aluminium.

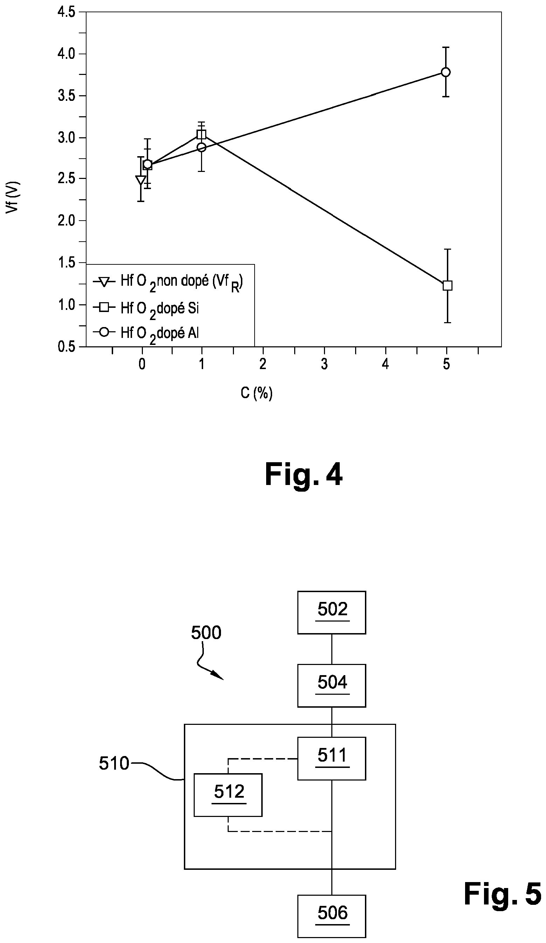

Ces phénomènes sont par exemple illustrés sur les courbes de la figure 4 qui représentent la variation de la tension de formation $V_f$ mesurée dans de l'oxyde de hafnium en fonction de la concentration atomique C de l'élément dopant présent dans l'oxyde de hafnium. Dans le cas du silicium, la tension de formation $V_f$ est supérieure à la tension de référence $V_{fR}$ lorsque la concentration atomique C en silicium est comprise entre 0,1% et 2%, et la valeur maximale de la tension de formation $V_f$ semble être atteinte pour une concentration C en silicium de l'ordre de 1%. Au contraire, la tension de formation $V_f$ est inférieure à la tension de référence $V_{fR}$ lorsque la concentration C en silicium est supérieure à 2%. Par contre, dans le cas de l'aluminium, la tension de formation $V_f$ est toujours supérieure à la tension de référence $V_{fR}$ quelle que soit la concentration atomique C en aluminium

Dans les différents modes de réalisation décrit par la suite, les cellules mémoires sont des cellules mémoire de type OxRAM dans lesquelles les électrodes 1, 2 sont en nitrure de titane, la couche d'oxyde 3 est en oxyde de hafnium et la couche de réservoir 9 est en titane. De plus, la couche d'oxyde 3 comporte une première zone 31 dopée avec de l'aluminium ou du silicium dans laquelle la concentration atomique en aluminium ou en silicium est choisie de manière à localiser la zone de commutation en dehors de la première zone 31. En d'autres termes, cela revient à faire en sorte que la première zone 31 dopée présente une première tension de formation supérieure à la tension de formation de référence dans la couche d'oxyde 3 non dopée. Ainsi, en appliquant à la cellule mémoire une tension de formation comprise entre la tension de référence et la première tension de formation, il est possible de former la zone de commutation hors de la première zone 31. La localisation de la zone de commutation dans la cellule mémoire est donc contrôlée, ce qui permet de réduire la variabilité entre les cellules mémoires.

Lorsque la première zone 31 est dopée avec du silicium, la concentration atomique en silicium dans la première zone 31 est de préférence comprise entre 0,5% et 1,5%, par exemple de l'ordre de 1%. Ainsi, en se référant à la figure 4, l'écart entre la première tension de formation et la tension de référence est maximisé.

Lorsque la première zone 31 est dopée avec de l'aluminium, la première tension de formation n'atteint pas de maximum. Dans ce cas, la concentration atomique en aluminium dans la première zone 31 est avantageusement choisie de manière à obtenir un écart suffisant entre la première tension de formation et la tension de référence pour s'assurer que la zone de commutation ne se forme pas dans la première zone 31. La concentration atomique en aluminium dans la première zone 31 est donc de préférence supérieure à 1%.

Un premier mode de réalisation d'une cellule mémoire 100 selon l'invention est illustré sur les figures 1A et 1B, qui représentent respectivement une vue en coupe transversale de la cellule mémoire 100, et une vue de dessus de la couche d'oxyde 3 de la cellule mémoire 100. La coupe transversale est réalisée selon la ligne de coupe I-I représentée sur la figure 1B.

Dans ce premier mode de réalisation, la première zone 31 s'étend à la périphérie de la cellule mémoire 100. Ainsi, la première tension de formation dans les bords dopés de la cellule mémoire 100 est plus élevée que la tension de formation de référence dans la partie non dopée de la couche d'oxyde 3, c'est-à-dire le centre de la cellule mémoire 100. Comme décrit précédemment, il est alors possible de former le filament au centre de la cellule mémoire 100 en appliquant à cette dernière une tension de formation comprise entre la tension de référence $V_{fR}$ et la première tension de formation.

La cellule mémoire peut appartenir à une matrice comportant une multitude de cellules mémoires adjacentes les unes aux autres. Il est connu dans l'art antérieur de graver la couche d'oxyde entre les cellules mémoires pour éviter la formation d'une zone de commutation entre l'électrode supérieure d'une première cellule mémoire et l'électrode inférieure d'une deuxième cellule mémoire adjacente à la première cellule mémoire. Grâce à l'invention, il n'est plus nécessaire de graver la couche d'oxyde 3 pour délimiter les cellules mémoires, la première zone 31 formant une zone d'exclusion pour la formation du filament. La couche d'oxyde 3 peut ainsi être partagée par plusieurs cellules mémoires, ce qui facilite leur fabrication.

Un deuxième mode de réalisation d'une cellule mémoire 200 selon l'invention est illustré sur les figures 2A et 2B, qui représentent respectivement une vue en coupe transversale de la cellule mémoire 200, et une vue de dessus de la couche d'oxyde 3 de la cellule mémoire 200. La coupe transversale est réalisée selon la ligne de coupe II-II représentée sur la figure 2B.

Dans ce deuxième mode de réalisation, la première zone 31 est dopée avec du silicium et la couche d'oxyde 3 comporte une deuxième zone 32 également dopée avec du silicium. La deuxième zone 32 est disposée au centre de la cellule mémoire 200. Le substrat s'étend selon un plan de référence XY dans lequel la première zone 31 entoure complétement la deuxième zone 32.

La concentration atomique en silicium dans la deuxième zone 32 est de préférence supérieure à 3%. Ainsi, en se référant à la figure 4, la deuxième zone 32 présente une deuxième tension de formation plus faible que la tension de formation de référence. Par conséquent, en réduisant la tension de formation appliquée à la cellule mémoire 200, la formation du filament est favorisée dans la deuxième zone 32. De plus, la première zone 31, dans laquelle la première tension de formation est plus élevée que la tension de référence, crée un effet de confinement du filament dans la deuxième zone 32 au centre de la cellule mémoire 200. La deuxième zone 32 forme un puits de potentiel pour la formation de la zone de commutation alors que la première zone 31 forme une barrière de potentiel.

Par ailleurs, en réduisant la tension de formation appliquée à la cellule mémoire 200, il est également possible de réduire la taille du circuit électronique fournissant la tension de formation, la taille du circuit électronique étant directement liée à la valeur de la tension de formation à fournir.

De préférence, la première zone 31 s'étend jusqu'à la périphérie de la cellule mémoire 200. Il est ainsi possible de se dispenser d'une étape de masquage lors de la fabrication de la cellule mémoire 200, comme décrit plus en détail par la suite.

Un troisième mode de réalisation d'une cellule mémoire 300 selon l'invention est illustré sur les figures 3A et 3B, qui représentent respectivement une vue en coupe transversale de la cellule mémoire 300, et une vue de dessus de la couche d'oxyde 3 de la cellule mémoire 300. La coupe transversale est réalisée selon la ligne III-III représentée sur la figure 3B.

Dans ce troisième mode de réalisation, la première zone 31 est dopée avec du silicium et la couche d'oxyde 3 comporte une deuxième zone 32 également dopée avec du silicium. La première zone 31 comporte une première portion 31a et une deuxième portion 31b qui s'étendent selon une première direction X, ainsi qu'une troisième portion 31c et une quatrième portion 31d qui s'étendent selon une deuxième direction Y sensiblement orthogonale à la première direction X. La première portion 31a et la deuxième portion 31b sont disposées de part et d'autre de la deuxième zone 32 de manière à ce qu'elles forment, avec la deuxième zone 32, une première tranchée 37 s'étendant selon la première direction X. Similairement, la troisième portion 31c et la quatrième portion 31d sont disposées de part et d'autre de la deuxième zone 32 de manière à ce qu'elles forment, avec la deuxième zone 32, une deuxième tranchée 38 s'étendant selon la deuxième direction Y. La première tranchée 37 et la deuxième tranchée 38 se croisent au niveau de la deuxième zone 32 qui est disposée au centre de la cellule mémoire 300.

Avantageusement, les concentrations atomiques en silicium dans la première tranchée 37 et dans la deuxième tranchée 38 sont chacune comprises entre 0,1% et 2% et la concentration atomique totale en silicium dans la deuxième zone 32, qui est égale à la somme des concentrations atomiques en silicium dans la première tranchée 37 et dans la deuxième tranchée 38, est supérieure à 3%. Ainsi, de manière similaire au deuxième mode de réalisation, la formation de la zone de commutation est favorisée dans la deuxième zone 32. Par exemple, les concentrations atomiques en silicium dans la première tranchée 37 et dans la deuxième tranchée 38 sont chacune de l'ordre de 1,5%.

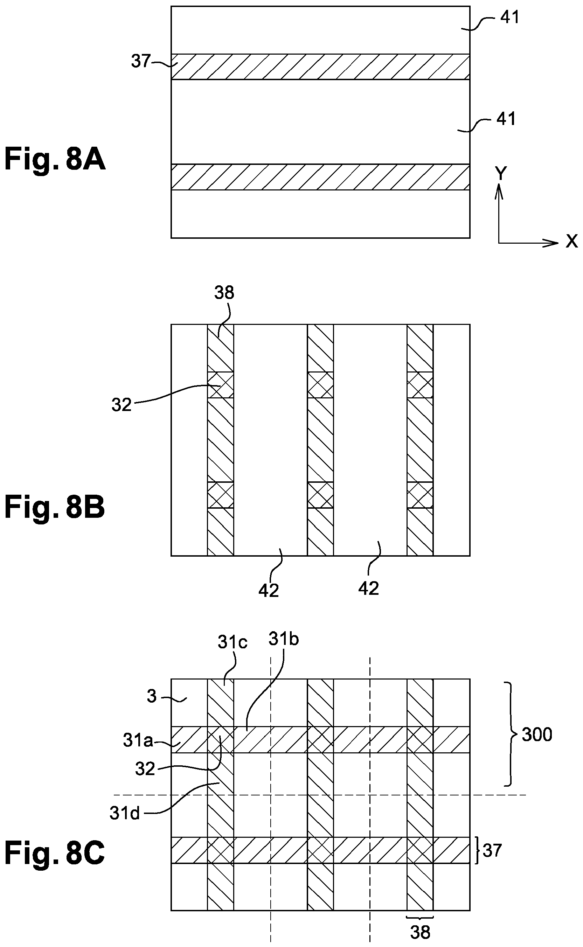

Comme décrit plus en détail par la suite en référence aux figures 8A à 8C, le dopage de la couche d'oxyde 3 est de préférence obtenu par implantation ionique. La taille minimale des zones implantées est donc limitée par les procédés de lithographie. Cette configuration comprenant deux régions de dopages sous forme de tranchées perpendiculaires permet de réaliser des motifs de petite taille à l'intersection des tranchées alors qu'il serait difficile de réaliser ces mêmes motifs de manière isolée, en une seule étape de lithographie.

La présente invention permet de contrôler la localisation de la zone de commutation en fonction du dopage de la couche d'oxyde 3. Dans les modes de réalisation décrits précédemment, la zone de commutation est localisée au centre de la cellule mémoire, ce qui permet d'améliorer les caractéristiques de la cellule mémoire telles que la rétention dans le temps et le nombre maximum de cycles. De plus, la localisation contrôlée de la zone de commutation permet d'éviter de graver la couche d'oxyde 3 pour délimiter les cellules mémoires, le filament ne risquant pas de se former entre deux cellules adjacentes.

Un autre aspect de l'invention concerne un procédé de fabrication 500 d'une cellule mémoire telle que celles décrites précédemment. La cellule mémoire appartient à une matrice comportant une multitude de cellules mémoires agencées en lignes et colonnes. Pour des raisons de simplification, seules quelques cellules mémoires sont représentées sur les figures accompagnant la description des étapes du procédé de fabrication 500.

Les étapes principales du procédé de fabrication 500 sont illustrées à la figure 5. Le procédé de fabrication 500 comporte une étape 502 de formation de l'électrode inférieure 1, une étape 504 de formation de la couche d'oxyde 3 et une étape 506 de formation de l'électrode supérieure 2. Ces différentes étapes de formation sont réalisées au moyen de procédés de dépôt connus tels que la pulvérisation, le dépôt par couches atomiques, également appelée ALD pour « Atomic Layer Déposition » en anglais, le dépôt physique en phase vapeur, également appelée PVD pour « Physical Vapor Déposition » en anglais, ou le dépôt chimique en phase vapeur, également appelée CVD pour « Chemical Vapor Déposition » en anglais.

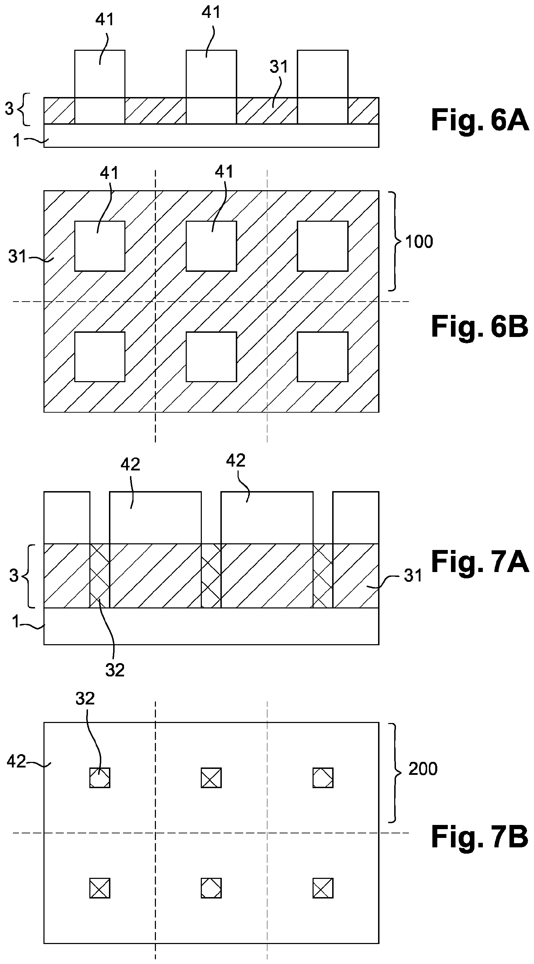

Au cours de l'étape 506 de formation de l'électrode supérieure 2, une couche électriquement conductrice est déposée sur la couche d'oxyde 3. Cette couche conductrice est ensuite gravée pour former l'électrode supérieure 2 de chaque cellule mémoire. La gravure de la couche conductrice suit par exemple un tracé représenté par des pointillés sur les figures 6B, 7B et 8C. L'électrode supérieure 2 de chaque cellule mémoire est ainsi isolée individuellement.

Dans d'autres modes de mises en œuvre, par exemple pour réaliser une architecture de type crossbar, la couche conductrice peut être gravée de manière à former des lignes ou des colonnes de cellules mémoires, chaque ligne ou chaque colonne ayant la même électrode supérieure 2.

Comme cela a déjà été dit précédemment, il n'est pas nécessaire de graver la couche d'oxyde 3 pour délimiter les cellules mémoires car la zone de commutation se forme de manière contrôlée dans une zone éloignée des bords de la cellule mémoire. La zone de commutation ne peut donc pas se former entre deux cellules mémoires adjacentes. La couche d'oxyde 3 et l'électrode inférieure 1 peuvent donc être communes à plusieurs cellules mémoires. En reprenant par exemple le cas de l'architecture crossbar dans laquelle l'électrode supérieure 2 est commune à plusieurs cellules mémoires disposées en colonne (respectivement en ligne), la couche d'oxyde 3 peut être gravée en même temps que la couche conductrice destinée à former l'électrode inférieure 1 de manière à former des lignes (respectivement des colonnes) de cellules mémoires.

Le procédé de fabrication 500 comporte également une étape 510 de formation dans la couche d'oxyde 3 de la première zone 31 dopée avec l'élément dopant, c'est-à-dire de l'aluminium ou du silicium en ce qui concerne le mode de réalisation de la figure 1A, et du silicium en ce qui concerne les modes de réalisation des figures 2A et 2B. De préférence, l'étape de formation de la première zone 31 comporte une première étape 511 d'implantation ionique d'aluminium ou de silicium. L'implantation ionique est un procédé très bien contrôlé, ce qui permet d'obtenir avec précision le dopage désiré dans la couche d'oxyde 3.

Pour obtenir la cellule mémoire 100 de la figure 1A, la première étape d'implantation 511 est effectuée dans la première zone 31. La première étape d'implantation 511 est avantageusement effectuée à une première dose choisie de manière à obtenir la concentration atomique en éléments dopants désirée. Par exemple, pour doper une couche d'oxyde de hafnium de 10nm d'épaisseur à une concentration atomique en silicium comprise entre 0,1 % et 2%, le silicium peut être implanté à une énergie de 4keV avec une dose comprise entre $8\times10^{13}$ atomes par cm$^{-2}$ et $1,6\times10^{15}$ atomes par cm$^{-2}$.

La première étape d'implantation 511 comporte avantageusement une première opération de masquage de la couche d'oxyde 3 de manière à exposer la première zone 31 à l'implantation ionique. Pour ce faire, un premier masque 41 est disposé sur la couche d'oxyde 3. Le premier masque 41 présente un motif qui diffère d'un mode de réalisation à un autre. Par exemple, les figures 6A et 6B montrent le motif utilisé pour obtenir la cellule mémoire 100 de la figure 1A.

L'étape de formation 510 de la première zone peut avantageusement comporter, en plus de la première étape d'implantation 511, une deuxième étape 512 d'implantation ionique de silicium dans une deuxième région de la couche d'oxyde, la première région et la deuxième région se confondant au moins partiellement et formant :

- la première zone de la couche d'oxyde dans laquelle la première région et la deuxième région ne sont pas confondues ; et
- une deuxième zone de la couche d'oxyde dans laquelle la première région et la deuxième région sont confondues ;

la première étape d'implantation (510) et la deuxième étape d'implantation étant effectuées à des doses telles que le silicium est présent dans la deuxième zone à une concentration atomique totale choisie de manière à localiser la zone de commutation dans la deuxième zone.

Pour obtenir la cellule mémoire 200 de la figure 2A, la première étape 511 d'implantation ionique de silicium est avantageusement réalisée sur toute la surface de la couche d'oxyde 3. Il est ainsi possible d'économiser la première opération de masquage, ce qui représente un gain de temps et d'argent.

Dans ce mode de mise en œuvre, l'étape de formation 510 comporte également une deuxième étape 512 d'implantation ionique du silicium dans la deuxième zone 32 de la couche d'oxyde 3. La deuxième étape d'implantation 512 comporte avantageusement une deuxième opération de masquage de la couche d'oxyde 3 de manière à exposer la deuxième zone 32 à l'implantation ionique. Pour ce faire, un deuxième masque 42 est disposé sur la couche d'oxyde 3. Le deuxième masque 42 présente un motif qui diffère d'un mode de réalisation à un autre. Par exemple, les figures 7A et 7B montrent le deuxième masque 42 utilisé pour obtenir la cellule mémoire 200 de la figure 2A.

Dans ce mode de mise en œuvre, la deuxième étape d'implantation 512 est effectuée à une deuxième dose choisie de manière à ce que la concentration atomique totale en silicium dans la deuxième zone 32 soit supérieure à 3%. Etant donné que la première étape d'implantation 511 est effectuée sur toute la surface de la couche d'oxyde 3, la deuxième dose implantée s'ajoute à la première dose implantée dans la deuxième zone 32.

Les figures 8A à 8C montrent un mode de mise en œuvre particulièrement avantageux du procédé de fabrication 500 permettant d'obtenir la cellule mémoire 300 de la figure 3A. La figure 8A montre le premier masque 41 utilisé pour former, au cours de la première étape d'implantation 511, les premières tranchées 37 s'étendant selon la première direction X. La figure 8B montre le deuxième masque 42 utilisé pour former, au cours de la deuxième étape d'implantation 512, les deuxièmes tranchées 38 s'étendant selon la deuxième direction Y. L'intersection des tranchées 31, 32 forment les deuxièmes zones 32 dans lesquelles les doses implantées s'ajoutent.

Avantageusement, les doses à implanter sont choisies de sorte que la concentration atomique en silicium dans chaque tranchée 37, 38 soit comprise entre 0,1% et 2% et que la concentration atomique totale en silicium dans la deuxième zone 32 soit supérieure à 3%. Ainsi, la formation de la zone de commutation est favorisée dans la deuxième zone 32. Ce mode de mise en œuvre exploite pleinement le profil de variation de la tension de formation en fonction de la concentration atomique, illustré à la figure 4. Il est ainsi possible de former facilement, par deux opérations successives de masquage, des motifs d'intersection de très petites dimensions, par exemple inférieures à 10nm, qui autrement seraient difficiles à réaliser en une seule opération de masquage.

Dans ce mode de mise en œuvre, l'électrode supérieure 2 de chaque cellule 300 est formée de manière à être disposée au-dessus de la deuxième zone 32, comme représenté par les pointillés sur la figure 8C.

Dans les différents modes de mises en œuvre du procédé de fabrication 500 décrits précédemment, la première étape d'implantation 511 et la deuxième étape d'implantation 512 peuvent être exécutées dans n'importe quel ordre.

Les différentes opérations de masquage de la couche d'oxyde 3 sont effectuées au moyen de procédés de lithographie connus tels la lithographie dans l'ultraviolet profond, par faisceau d'électrons, ou basée sur l'auto-assemblage de copolymères à blocs.

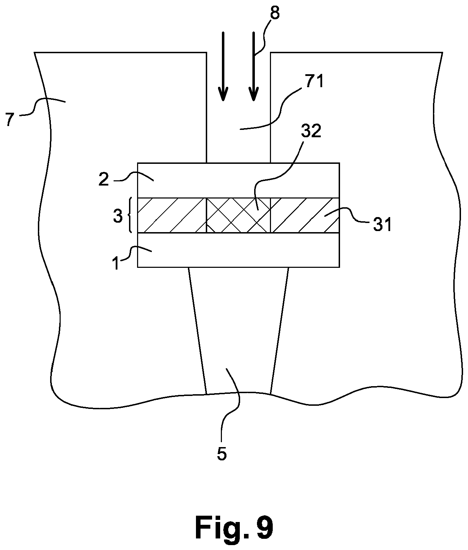

La figure 9 illustre la deuxième étape d'implantation ionique selon un autre mode de mise en œuvre du procédé de l'invention. Dans ce cas, la cellule mémoire est formée sur un contact électrique 5 qui connecte électriquement la première électrode 1 par exemple à un circuit (non représenté) formé dans des couches inférieures sur le substrat. Cette cellule mémoire est encapsulée dans un matériau isolant 7, tel qu'un oxyde de silicium (SiO$_x$), qui est ensuite planarisé par exemple au moyen d'un procédé de planarisation mécano-chimique, également appelé CMP pour « chemical-mechanical planarization.

Une ouverture 71 est réalisée dans le matériau isolant 7 de manière à pouvoir former un contact électrique sur la deuxième électrode 2. Avantageusement, le matériau isolant 7 est utilisé comme masque pour réaliser la deuxième étape d'implantation ionique, symbolisée par des flèches 8, à travers l'ouverture 71. On évite ainsi d'avoir une étape de formation d'un masque spécifique à la deuxième étape d'implantation ce qui permet de diminuer le coût et le temps de fabrication de la cellule mémoire. De plus, la zone de commutation de la cellule mémoire est ainsi alignée avec le contact électrique de la deuxième électrode 2 ce qui est particulièrement avantageux dans le cas de cellule mémoires présentant de faibles dimensions latérales, par exemple sensiblement égales à celles du contact électrique. En évitant une étape de masquage supplémentaire, on minimise les désalignements entre les différentes couches ce qui facilite la diminution de la taille des cellules mémoires.

Naturellement, l'invention n'est pas limitée aux modes de réalisation décrits en référence aux figures et des variantes pourraient être envisagées sans sortir du cadre de l'invention.

Dans une variante de mise œuvre, plusieurs étapes d'implantation ionique peuvent être effectuées en utilisant un seul masque. Les ions implantés proviennent d'une source qui, à chaque étape d'implantation, forme un angle d'incidence avec une direction normale au plan du substrat. Entre chaque étape d'implantation, la position relative de la source par rapport au substrat est alors modifiée de sorte que les ions implantés proviennent de plusieurs directions. Par exemple, dans le cas où quatre étapes d'implantation sont effectuées, la position relative de la source par rapport au substrat peut être modifiée d'un quart de tour.

Cette variante de mise en œuvre permet d'obtenir dans une zone ainsi dopée un gradient de la concentration atomique en éléments dopants qui implique un gradient de la tension de formation. En effet, la zone implantée est délimitée pas les bords du masque. La source des ions étant inclinée par rapport au plan du substrat, la concentration atomique en éléments dopants dans la zone implantée est la plus faible près des bords du masque et augmente progressivement jusqu'au centre de la zone implantée.

Dans une autre variante de mise œuvre, les étapes d'implantation peuvent être effectuées, toutes ou en partie seulement, après le dépôt sur la couche d'oxyde 3 de la couche conductrice électriquement destinée à former l'électrode supérieure 2. Les éléments dopants sont alors implantés au travers de la couche conductrice. Ainsi, par exemple, les masques utilisés pour déposer des contacts métalliques sur l'électrode supérieure 2 peuvent être préalablement utilisés pour implanter les éléments dopants dans la couche d'oxyde 3.

## Revendications

1. Cellule mémoire (100, 200, 300) non-volatile résistive comportant une première électrode (1), une deuxième électrode (2) et une couche d'oxyde (3) disposée entre la première électrode et la deuxième électrode, la cellule mémoire étant apte à commuter de manière réversible entre :

   - un état à forte résistance obtenu en appliquant une première tension de polarisation entre la première électrode et la deuxième électrode ; et
   - un état à faible résistance en appliquant une deuxième tension de polarisation entre la première électrode et la deuxième électrode ;

   la couche d'oxyde comportant une zone de commutation formant un chemin de conduction privilégié au courant traversant la cellule mémoire lorsque la cellule mémoire est à l'état à faible résistance, la cellule mémoire étant **caractérisée en ce que** la couche d'oxyde comporte une première zone (31) dopée avec de l'aluminium ou du silicium, l'aluminium ou le silicium étant présent dans la première zone à une concentration atomique choisie de manière à localiser la zone de commutation en dehors de la première zone.

2. Cellule mémoire (100, 200, 300) selon la revendication 1 **caractérisée en ce que** la première zone (31) s'étend à la périphérie de la cellule mémoire.

3. Cellule mémoire (100, 200, 300) selon l'une quelconque des revendications 1 à 2 **caractérisée en ce que** la première zone (31) est dopée avec du silicium, la concentration atomique en silicium dans la première zone étant comprise entre 0,1% et 2%.

4. Cellule mémoire (200, 300) selon la revendication 3 **caractérisée en ce que** la couche d'oxyde (3) comporte une deuxième zone (32) dopée avec du silicium, le silicium étant présent dans la deuxième zone à une concentration atomique choisie de manière à localiser la zone de commutation dans la deuxième zone.

5. Cellule mémoire (200) selon la revendication 4 **caractérisée en ce que** la première zone entoure complètement la deuxième zone.

6. Cellule mémoire (300) selon la revendication 4 **caractérisée en ce que** la première zone (31) comporte :

   - une première portion et une deuxième portion s'étendant de part et d'autre de la deuxième zone selon une première direction (X) ;
   - une troisième portion et une quatrième portion s'étendant de part et d'autre de la deuxième zone selon une deuxième direction (Y) sensiblement orthogonale à la première direction.

7. Cellule mémoire (200, 300) selon l'une quelconque des revendications 1 à 6 **caractérisée en ce que** la concentration atomique (C) en silicium dans la deuxième zone est supérieure à 3%.

8. Cellule mémoire (100, 200, 300) selon l'une quelconque des revendications 1 à 7 **caractérisée en ce que** la couche d'oxyde (3) comporte un matériau parmi les suivants : oxyde de hafnium, oxyde de tantale.

9. Procédé de fabrication (500) d'une cellule mémoire (100, 200, 300) non-volatile résistive comportant une première électrode (1), une deuxième électrode (2) et une couche d'oxyde (3) disposée entre la première électrode et la deuxième électrode, la cellule mémoire étant apte à commuter de manière réversible entre :

   - un état à forte résistance obtenu en appliquant une première tension de polarisation entre la première électrode et la deuxième électrode ; et
   - un état à faible résistance en appliquant une deuxième tension de polarisation entre la première électrode et la deuxième électrode ;

   la couche d'oxyde comportant une zone de commutation formant un chemin de conduction privilégié au courant traversant la cellule mémoire lorsque la cellule mémoire est à l'état à faible résistance, le procédé étant **caractérisé en ce qu'**il comporte une étape (510) de formation dans la couche d'oxyde d'une première zone (31) dopée avec de l'aluminium ou du silicium, l'aluminium ou le silicium étant présent dans la première zone à une concentration atomique choisie de manière à localiser la zone de commutation en dehors de la première zone.

10. Procédé (500) selon la revendication 9 **caractérisé en ce que** l'étape de formation comporte une première étape d'implantation ionique d'aluminium ou de silicium dans la première zone.

11. Procédé (500) selon la revendication 9 **caractérisé en ce que** l'étape de formation comporte une première étape d'implantation ionique de silicium dans une première région de la couche d'oxyde et une deuxième étape d'implantation ionique de silicium dans une deuxième région de la couche d'oxyde, la première région et la deuxième région se confondant au moins partiellement et formant :

   - la première zone de la couche d'oxyde dans laquelle la première région et la deuxième région ne sont pas confondues ; et
   - une deuxième zone de la couche d'oxyde dans laquelle la première région et la deuxième région sont confondues ;

   la première étape d'implantation (510) et la deuxième étape d'implantation étant effectuées à des doses telles que le silicium est présent dans la deuxième zone à une concentration atomique totale choisie de manière à localiser la zone de commutation dans la deuxième zone.

12. Procédé (500) selon la revendication 11 **caractérisé en ce que** la première étape d'implantation (510) comporte une première opération de masquage de la couche d'oxyde (3) réalisée de manière à ce que la première région (31) forme une première tranchée s'étendant selon une première direction (X), et **en ce que** la deuxième étape d'implantation (512) comporte une deuxième opération de masquage de la couche d'oxyde réalisée de manière à ce que la deuxième région (32) forme une deuxième tranchée s'étendant selon une deuxième direction (Y) sensiblement orthogonale à la première direction, la deuxième tranchée croisant la première tranchée, la deuxième zone étant formée par l'intersection de la première tranchée et de la deuxième tranchée.

13. Procédé (500) selon l'une quelconque des revendications 10 à 12 **caractérisé en ce qu'**il comporte une étape de dépôt, sur la couche d'oxyde (3), d'une couche conductrice électriquement destinée à former une électrode (2), la première étape d'implantation (510) et/ou la deuxième étape d'implantation (512) étant effectuées après l'étape de dépôt de la couche conductrice électriquement.

**Patentansprüche**

1.  Resistive, nicht flüchtige Speicherzelle (100, 200, 300), umfassend eine erste Elektrode (1), eine zweite Elektrode (2) und eine Oxidschicht (3), die zwischen der ersten Elektrode und der zweiten Elektrode angeordnet ist, wobei die Speicherzelle geeignet ist, umkehrbar umzuschalten zwischen:

    - einem Zustand mit starkem Widerstand, der durch Anwenden einer ersten Polarisationsspannung zwischen der ersten Elektrode und der zweiten Elektrode erhalten ist; und;
    - einem Zustand mit geringem Widerstand durch Anwenden einer zweiten Polarisationsspannung zwischen der ersten Elektrode und der zweiten Elektrode;
    wobei die Oxidschicht einen Umschaltbereich umfasst, der einen privilegierten Umschaltbereich für den Strom umfasst, der die Speicherzelle durchströmt, wenn die Speicherzelle im Zustand mit niedrigem Widerstand ist, wobei die Speicherzelle **dadurch gekennzeichnet ist, dass** die Oxidschicht einen ersten, mit Aluminium oder Silizium gedopten Bereich (31) umfasst,
    wobei das Aluminium oder das Silizium in dem ersten Bereich in einer Atomkonzentration vorhanden ist, die derart ausgewählt ist, dass der Umschaltbereich außerhalb des ersten Bereichs angeordnet ist.

2.  Speicherzelle (100, 200, 300) gemäß Anspruch 1, **dadurch gekennzeichnet, dass** der erste Bereich (31) sich an der Peripherie der Speicherzelle erstreckt.

3.  Speicherzelle (100, 200, 300) gemäß irgendeinem der Ansprüche 1 bis 2, **dadurch gekennzeichnet, dass** der erste Bereich (31) mit Silizium gedopt ist, wobei die Atomkonzentration an Silizium in dem ersten Bereich zwischen 0,1 % und 2 % inbegriffen ist

4.  Speicherzelle (200, 300) gemäß Anspruch 3, **dadurch gekennzeichnet, dass** die Oxidschicht (3) einen zweiten, mit Silizium gedopten Bereich (32) umfasst, wobei das Silizium in dem zweiten Bereich in einer Atomkonzentration vorhanden ist, die derart ausgewählt ist, dass der Umschaltbereich in dem zweiten Bereich angeordnet ist.

5.  Speicherzelle (200) gemäß Anspruch 4, **dadurch gekennzeichnet, dass** der erste Bereich den zweiten Bereich vollständig umschließt.

6.  Speicherzelle (300) gemäß Anspruch 4, **dadurch gekennzeichnet, dass** der erste Bereich (31) umfasst:

    - einen ersten Abschnitt und einen zweiten Abschnitt, die sich auf jeder Seite des zweiten Bereichs gemäß einer ersten Richtung (X) erstrecken;
    - einen dritten Abschnitt und einen vierten Abschnitt, die sich auf jeder Seite des zweiten Bereichs gemäß einer zweiten Richtung (Y) erstrecken, die zur ersten Richtung deutlich orthogonal ist.

7.  Speicherzelle (200, 300) gemäß irgendeinem der Ansprüche 1 bis 6, **dadurch gekennzeichnet, dass** die Atomkonzentration (C) aus Silizium in dem zweiten Bereich höher als 3 % ist.

8.  Speicherzelle (100, 200, 300) gemäß irgendeinem der Ansprüche 1 bis 7, **dadurch gekennzeichnet, dass** die Oxidschicht (3) ein Material aus den folgenden umfasst: Hafniumoxid, Tantaloxid.

9.  Herstellungsverfahren (500) einer resistiven, nicht flüchtigen Speicherzelle (100, 200, 300), umfassend eine erste Elektrode (1), eine zweite Elektrode (2) und eine Oxidschicht (3), die zwischen der ersten Elektrode und der zweiten Elektrode angeordnet ist, wobei die Speicherzelle geeignet ist, umkehrbar umzuschalten zwischen:

    - einem starken Widerstandszustand, der durch Anwenden einer ersten Polarisationsspannung zwischen der ersten Elektrode und der zweiten Elektrode erhalten wird; und
    - einem schwachen Widerstandszustand durch Anwenden einer zweiten Polarisationsspannung zwischen der ersten Elektrode und der zweiten Elektrode;

    wobei die Oxidschicht einen Umschaltbereich umfasst, der einen privilegierten Leitungsweg für den Strom bildet, der die Speicherzelle durchströmt, wenn die Speicherzelle im schwachen Widerstandszustand ist, wobei das Verfahren **dadurch gekennzeichnet ist, dass** es einen Bildungsschritt (510) in der Oxidschicht eines ersten mit Aluminium oder Silizium gedopten Bereichs (31) umfasst, wobei das Aluminium oder das Silizium in dem ersten Bereich in einer Atomkonzentration vorhanden ist, die derart ausgewählt wird, dass der Umschaltbereich außerhalb des ersten Bereichs angeordnet ist.

10.  Verfahren (500) gemäß Anspruch 9, **dadurch gekennzeichnet, dass** der Bildungsschritt einen ersten ionischen Aluminium- oder Silizium-Einbauschritt in dem ersten Bereich umfasst.

11.  Verfahren (500) gemäß Anspruch 9, **dadurch gekennzeichnet, dass** der Bildungsschritt einen ersten ionischen Silizium-Einbauschritt in einer ersten Region der Oxidschicht und einen zweiten ionischen Silizium-Einbauschritt in einer zweiten Region der Oxidschicht umfasst, wobei die erste Region und die zweite Region wenigstens teilweise zusammenfallen und bilden:

- den ersten Bereich der Oxidschicht, in der die erste Region und die zweite Region nicht zusammenfallen; und
- einen zweiten Bereich der Oxidschicht, in der die erste Region und die zweite Region zusammenfallen;

wobei der erste Einbauschritt (510) und der zweite Einbauschritt in derartigen Dosen durchgeführt werden, dass das Silizium in dem zweiten Bereich in einer Gesamt-Atomkonzentration vorhanden ist, die derart ausgewählt wird, dass der Umschaltbereich in dem zweiten Bereich angeordnet ist.

12. Verfahren (500) gemäß Anspruch 11, **dadurch gekennzeichnet, dass** der erste Einbauschritt (510) eine erste Abdeckoperation der Oxidschicht (3) umfasst, die derart realisiert wird, dass die erste Region (31) eine erste Vertiefung bildet, die sich gemäß einer ersten Richtung (X) erstreckt, und dass der zweite Einbauschritt (512) eine zweite Abdeckoperation der Oxidschicht umfasst, die derart realisiert wird, dass die zweite Region (32) eine zweite Vertiefung bildet, die sich gemäß einer zweiten, zur ersten Richtung deutlich orthogonalen Richtung (Y) erstreckt, wobei die zweite Vertiefung die erste Vertiefung kreuzt, wobei der zweite Bereich per Schneiden der ersten Vertiefung und der zweiten Vertiefung gebildet wird.

13. Verfahren (500) gemäß irgendeinem der Ansprüche 10 bis 12, **dadurch gekennzeichnet, dass** es einen Aufbringungsschritt einer zum Bilden einer Elektrode (2) bestimmten elektrisch leitenden Schicht auf der Oxidschicht (3) umfasst, wobei der erste Einbauschritt (510) und/oder der zweite Einbauschritt (512) nach dem Aufbringungsschritt der elektrisch leitenden Schicht durchgeführt werden.

**Claims**

1. Resistive non-volatile memory cell (100, 200, 300) comprising a first electrode (1), a second electrode (2) and an oxide layer (3) arranged between the first electrode and the second electrode, the memory cell being capable of reversibly switching between:

- a high resistance state obtained by applying a first bias voltage between the first electrode and the second electrode; and
- a low resistance state obtained by applying a second bias voltage between the first electrode and the second electrode;

the oxide layer comprising a switching zone forming a favoured conduction path for the current passing through the memory cell when the memory cell is in the low resistance state, the memory cell being **characterised in that** the oxide layer comprises a first zone (31) doped with aluminium or silicon, the aluminium or silicon being present in the first zone at an atomic concentration that is selected so as to locate the switching zone outside the first zone.

2. Memory cell (100, 200, 300) according to claim 1, **characterised in that** the first zone (31) extends to a periphery of the memory cell.

3. Memory cell (100, 200, 300) according to any of claims 1 to 2, **characterised in that** the first zone (31) is doped with silicon, the atomic concentration of silicon in the first zone being comprised between 0.1% and 2%.

4. Memory cell (200, 300) according to claim 3, **characterised in that** the oxide layer (3) comprises a second zone (32) doped with silicon, the silicon being present in the second zone at an atomic concentration that is selected so as to locate the switching zone in the second zone.

5. Memory cell (200) according to claim 4, **characterised in that** the first zone completely surrounds the second zone.

6. Memory cell (300) according to claim 4, **characterised in that** the first zone (31) comprises:

- a first portion and a second portion extending on either side of the second zone along a first direction (X);
- a third portion and a fourth portion extending on either side of the second zone along a second direction (Y) substantially orthogonal to the first direction.

7. Memory cell (200, 300) according to any of claims 1 to 6, **characterised in that** the atomic concentration (C) of silicon in the second zone is greater than 3%.

8. Memory cell (100, 200, 300) according to any of claims 1 to 7, **characterised in that** the oxide layer (3) comprises a material among the following: hafnium oxide, tantalum oxide.

9. Method for manufacturing (500) a resistive non-volatile memory cell (100, 200, 300) comprising a first electrode (1), a second electrode (2) and an oxide layer (3) arranged between the first electrode and the second electrode, the memory cell being capable of reversibly switching between:

- a high resistance state obtained by applying a first bias voltage between the first electrode and the second electrode; and
- a low resistance state obtained by applying a second bias voltage between the first electrode and the second electrode;

the oxide layer comprising a switching zone forming a favoured conduction path for the current passing through the memory cell when the memory cell is in the low resistance state, the method being **characterised in that** it comprises a step (510) of formation in the oxide layer of a first zone (31) doped with aluminium or silicon, the aluminium or silicon being present in the first zone at an atomic concentration that is selected so as to locate the switching zone outside the first zone.

10. Method (500) according to claim 9 **characterised in that** the step of formation comprises a first step of ion implantation of aluminium or silicon in the first zone.

11. Method (500) according to claim 9 **characterised in that** the step of formation comprises a first step of ion implantation of silicon in a first region of the oxide layer and a second step of ion implantation of silicon in a second region of the oxide layer, the first region and the second region merging at least partially and forming:

- the first zone of the oxide layer in which the first region and the second region are not merged; and
- a second zone of the oxide layer in which the first region and the second region are merged;

the first implantation step (510) and the second implantation step being carried out at doses such that silicon is present in the second zone at a total atomic concentration that is selected so as to locate the switching zone in the second zone.

12. Method (500) according to claim 11 **characterised in that** the first implantation step (510) comprises a first operation of masking the oxide layer (3) carried out in such a way that the first region (31) forms a first trench extending along a first direction (X), and **in that** the second implantation step (512) comprises a second operation of masking the oxide layer carried out in such a way that the second region (31) forms a second trench extending along a second direction (Y) substantially orthogonal to the first direction, the second trench crossing the first trench, the second zone being formed by the intersection of the first trench and the second trench.

13. Method (500) according to any of claims 10 to 12 **characterised in that** it comprises a step of deposition, on the oxide layer (3), of an electrically conductive layer intended to form an electrode (2), the first implantation step (510) and/or the second implantation step (512) being carried out after the step of deposition of the electrically conductive layer.

**Fig. 1A**

**Fig. 1B**

**Fig. 2A**

**Fig. 2B**

**Fig. 3A**

**Fig. 3B**

**Fig. 4**

**Fig. 5**

41  41  31

3 {

1

**Fig. 6A**

41  41

31

100

**Fig. 6B**

42  42

3 {

1

31

32

**Fig. 7A**

32

42

200

**Fig. 7B**

**Fig. 8A**

41

37

41

Y

X

**Fig. 8B**

38

32

42          42

**Fig. 8C**

31c    31b

3

31a

32

31d

300

37

38

**Fig. 9**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2012295398 A
- US 201269624 B
- US 2014322887 A

**Littérature non-brevet citée dans la description**

- **HAYAKAWA Y. et al.** Highly reliable TaOx ReRAM with centralized filament for 28-nm embedded application. *Symposium on VLSI Technology, Kyoto,* 2015, ISSN 0743-1562